# EUROPEAN PATENT APPLICATION

(11) **EP 0 572 150 A2**
(43) Date of publication of application: **01.12.1993**
(21) Application number: 93303799.6
(22) Date of filing: 17.05.1993
(51) Int. Cl.: C23C 16/08, C23C 16/44, C23C 16/12

(54) **Chemical vapour-deposition of aluminide coatings**

(30) Priority: 26.05.1992 US 887969
(71) Applicant: GENERAL ELECTRIC COMPANY, Schenectady, NY 12345 (US)
(72) Inventor: Cybulsky, Michael, Cincinnati, Ohio 45242 (US); Reeves, Jim Dean, Cincinnati, Ohio 45249 (US); Frandoni, Gary Lee, West Chester, Ohio 45069 (US); Vakil, Himanshu Bachubhai, Schenectady, New York 12305 (US)
(74) Representative: Pratt, Richard Wilson

(57) **Abstract**

The present invention provides a method and apparatus for coating nickel based alloy articles with NiAl coatings and cobalt based alloy articles with CoAl coatings by generating an aluminum chloride gas mixture with increased levels of AlCl in a vapor generator at a first temperature T1 and flowing the resultant AlCl enriched aluminum chloride gases over the articles to be coated in a reactor at a second temperature T2 wherein T2 is at a substantially lower temperature than T1, having a difference of at least 25°F and preferably about 150°F.

## Description

### BACKGROUND OF THE INVENTION

### Field of the Invention

This invention relates to vapor deposition of aluminide coatings on metallic articles and more particularly to a method for forming NiAl coatings on nickel based alloys and CoAl coatings on cobalt based alloys.

### Description of Related Art

Vapor deposition of metallic coatings on parts by vapor deposition is well known in many fields and in particular for use in aircraft gas turbine engines. Conventionally, parts and components made of nickel based alloys and cobalt based alloys are coated using chemical vapor deposition (CVD) of aluminide coatings to improve their resistance to wear and chemical oxidation in hot and corrosive environments.

A typical method of chemical vapor deposition of aluminide coatings provides for reacting a halide activator base with an aluminum containing powder in a conventional pack aluminiding process. Anther typical method provides for passing aluminide chloride gases across a molten pool of aluminum to generate aluminum containing vapors from which aluminum is deposited on components in a reactor. The aluminide coatings thus produced are deposited and diffused simultaneously during the same step in the single reactor.

The pack aluminiding process has limitations in that handling, disposal and replenishment of the powders is very cumbersome and expensive compared to CVD aluminiding. The generation of coating vapors in a separate generator results in coatings which exhibit better composition and thickness control than in reactors where coating vapors are generated and deposited at a single temperature.

Therefore a primary objective of the present invention is to provide a thicker more consistent coating. CVD processes are also rather slow and expensive and therefore another object of the present invention is to provide a method and system that provide NiAl coatings on nickel based alloys and CoAl coatings on cobalt based alloys in a quick, efficient, and economical manner.

### SUMMARY OF THE INVENTION

The present invention provides a method and apparatus for coating nickel based alloy articles with NiAl coatings and cobalt based alloy articles with CoAl coatings by generating aluminum chloride gases with increased concentrations of AlCl in a vapor generator at a first temperature T1 and flowing the resultant AlCl enriched aluminum chloride gases over the articles to be coated in a reactor at a second temperature T2 wherein T2 is at a substantially lower temperature than T1, and the difference between the two temperatures is at least 25°F and preferably about 150°F.

The preferred embodiment includes generating the AlCl enriched aluminum chloride gases by passing hydrogen chloride HCl gas through a pre-generator containing aluminum pellets, preferably at about 500°F, to form aluminum trichloride gas AlCl₃ and hydrogen, which is then supplied to the generator. The generator, at a much higher temperature, creates aluminum monochloride AlCl by passing the aluminum chloride gases through aluminum containing pellets or through liquid aluminum at temperatures substantially higher than those in the reactor. This process would normally produce an aluminum chloride gas mixture containing aluminum monochloride AlCl and aluminum sub-halides or sub-chlorides such as aluminum dichloride AlCl₂ and aluminum trichloride AlCl₃. This mixture is referred to herein as aluminum chloride gas mixture, while the individual components of the mixture are referred to as aluminum monochloride or HCl, aluminum dichloride or HCl₂ and aluminum trichoride or HCl₃.

The present invention provides a means for producing this gas mixture with elevated or higher concentrations of AlCl so as to form an aluminum monochloride AlCl-enriched gas mixture. One embodiment provides a means for generating an aluminum monochloride AlCl-enriched aluminum chloride gas mixture by conventional bubbling whereby the aluminum chloride gases are bubbled through a container of molten aluminum while holding the reactor and generator differential temperatures at the above specified levels. Other embodiments provide means for generating an aluminum monochloride AlCl enriched aluminum chloride gas mixture by passing hydrogen chloride or aluminum trichloride gases through aluminum alloy pellets, that will not melt at the high temperature of the generator. The resultant AlCl enriched aluminum chloride gas mixture is then passed over the surfaces of the articles to be coated.

### ADVANTAGES

Among the advantages provided by the present invention is that metallic based alloy articles having a base metal from the group including cobalt (Co) and nickel (Ni) may be coated with aluminum more quickly, efficiently, and economically and with a thicker coating than has previously been available. The aluminum supplied by the process of the present invention combines with the Ni or Co of the metallic alloy to form intermetallic compounds as coatings on the exposed surface of the alloy articles. Portions of the article which are not to be coated are masked to prevent contact with the gas vapor. The intermetallic compounds generally take the form of NiAl or CoAl, but other stoichiometric intermetallic compounds, for example NiAl₃ may form.

Another advantage provided by the present invention is the ability to independently control the temperatures in the temperature generator and reactor to permit greater control of the process. The present invention forms an aluminum chloride gas mixture at a higher temperature, and therefore enriched in AlCl, but coats the article at lower temperature which increases deposition rates over conventional coating processes.

### BRIEF DESCRIPTION OF THE DRAWINGS

The foregoing aspects and other features of the invention are explained in the following description, taken in connection with the accompanying drawings where:

FIG. 1 is a schematic diagram of the method and apparatus for aluminum coating certain metallic based articles in accordance with the preferred embodiment of the present invention.

FIG. 2 is a schematic diagram of an alternate method and apparatus for aluminum coating certain metallic based articles in accordance with the present invention.

### DETAILED DESCRIPTION OF THE INVENTION

The preferred embodiment of the present invention provides a process which enhances the chemical vapor deposition process through the use of an external generator. The CVD aluminide coating process utilizes the following reactions:

1. AlCl₃ + 2Al --_ 3 AlCl (g)

2. 2Ni + H₂ + 2 AlCl --_ 2 NiAl + 2 HCl

3. 2Ni + 3AlCl --_ 2NiAl+AlCl₃

The aluminum monochloride gas AlCl producing reaction above create an aluminum chloride gas mixture denoted as AlCl_{X} including aluminum monochloride AlCl and aluminum sub-halides or sub-chlorides such as aluminum dichloride AlCl₂ and aluminum trichloride AlCl₃. In order to optimize the CVD process it is necessary to form as much AlCl as thermodynamically possible. This reaction is generally favored at higher temperatures. Reaction 2 or 3 can then proceed forming a NiAl coating on a nickel base alloy or CoAl on a cobalt base alloy. Through the use of an external generator the above reactions can be enhanced by performing reaction 1 in a separate high temperature generator and then reaction 2 or 3 at a lower temperature in a separate reactor thereby increasing the deposition rate due to the favorable amount of AlCl.

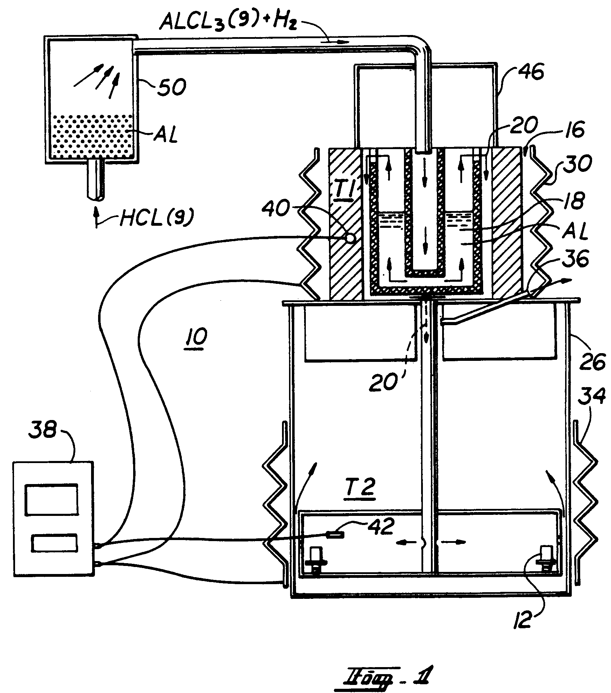

FIG. 1 is a schematic diagram depicting a chemical vapor deposition (CVD) coating method and a CVD apparatus 10 for depositing a coating of aluminum on the surface of an article 12, such as gas turbine engine blades, made of an alloy having a base metal selected from a group of metals including cobalt (Co) and nickel (Ni). Among the important features of CVD apparatus 10 is a generator 16 for generating an AlCl enriched aluminum chloride gas mixture 20 by continuously flowing AlCl₃ gases into the generator 16 and forming an aluminum chloride gas mixture AlCl_{X} containing aluminum monochloride AlCl, aluminum dichloride AlCl₂, and aluminum trichloride AlCl₃ gases, but having an enriched AlCl component in the aluminum chloride gas mixture 20.

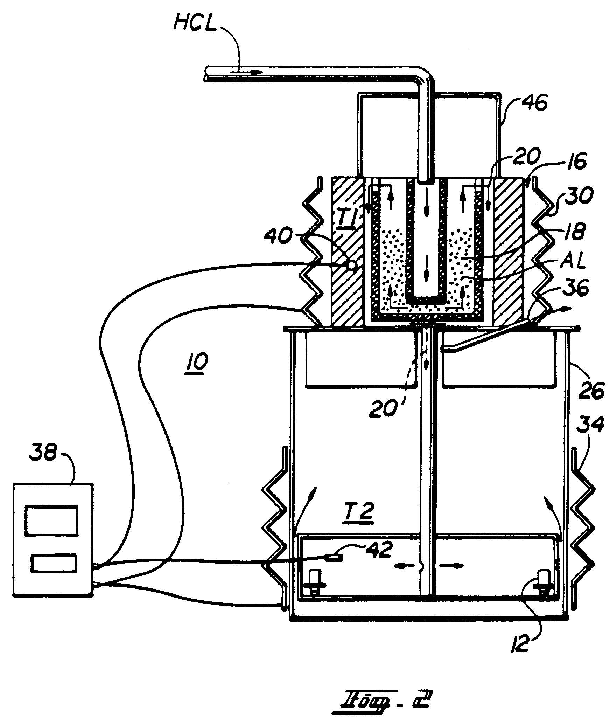

Alternatively, as schematically shown in FIG. 2, HCl may be continuously flowed into the generator 16. These aluminum chloride gases form by contact of AlCl₃ or HCl with aluminum, shown in a chamber 18, in the form of liquid aluminum or aluminum containing pellets in the form of aluminum alloy pellets that will not melt at the operating temperaures of the generator. Aluminum containing pellets are usually in the form of aluminum chromium pellets denoted by AlCr.

The method for producing an aluminum monochloride AlCl enriched aluminum chloride gas mixture 20 for the embodiment shown in FIG. 1 is referred to as bubbling which incorporates a chamber 18 filled with liquid aluminum Al and provides a means to flow the aluminum trichloride gas AlCl₃ under pressure into the liquid aluminum to form the aluminum monochloride AlCl enriched aluminum chloride gas mixture 20. Generator 16 is in fluid supply communication with a reactor 26 which is preferably located below the generator and effective for receiving the AlCl enriched aluminum chloride gas mixture 20. Located within reactor 26 are articles 12 that are arranged to allow the AlCl enriched aluminum chloride gas mixture 20 to be flowed over the exposed surfaces of the articles to form an aluminum coating on the exposed surfaces of the articles. Alternatively the aluminum Al in chamber 18 may be in pellet form.

Illustrated in FIG. 2 is an another embodiment incorporating a different method for producing the aluminum monochloride AlCl enriched aluminum chloride gas mixture 20. The embodiment in FIG. 2 provides a means to flow hydrogen chloride HCl gas into chamber 18 which contains aluminum Al in preferably pellet form to produce the aluminum monochloride AlCl-enriched aluminum chloride gas mixture 20 without a pre-generator.

Conventional pack type CVD processes that use powders packed around the parts have limitations in handling, disposal and replenishment of the powder and can be very cumbersome and expensive compared with charging and recharging the aluminum powder and pellets in a high temperature generator such as that used in the present invention.

An important feature of the present invention, as illustrated in both FIGS. 1 and 2, is to maintain a favorable level of AlCl in the AlCl-enriched aluminum chloride gas mixture 20. This is accomplished by maintaining a first temperature T1 in the generator 16 and a second temperature T2 in the reactor 26 such that temperature T1 remains substantially higher than said second temperature T2 during the reacting step of the coating process. It has been found that a temperature difference between T1 and T2 of as little as 25°F is sufficient and that a difference of about 150°F is preferred. Furthermore it is preferable to maintain the first temperature T1 in a range of about 1800°F to 2300°F and the second temperature T2 in range of about 1500°F to 2200°F.

Referring to FIGS. 1 and 2, the desired temperature levels and differences are maintained by a first heating means 30 in the form of an electrical furnace surrounding generator 16, and effective for maintaining the first temperature T1 in the generator and a second heating means 34 effective for maintaining the second temperature T2 in the reactor 26. A vent means 36 leading from reactor 26 vents the reacted gases to scrubbers (not shown).

A control means to continuously monitor and control the coating process and to operate the furnaces to maintain the desired temperature levels and differences is another feature of the preferred embodiment. The control means includes a first temperature sensing means, illustrated as a first thermocouple 40, to measure and output a first signal indicative of the first temperature T1 in the generator 16 and a second temperature sensing means, illustrated as a second thermocouple 42, to measure and output a second signal indicative of said second temperature T2. The first and second temperature signals are transmitted to a programmable computing means 38, via signal lines shown in FIG. 1, which is effective to receive the first and second temperature signals and control the first and second heating means 30 and 34 respectively to maintain a preselected first and second temperature schedule in accordance with the requirements of the present invention as well as other criteria relating to the process.

The preferred embodiment also provides for generating a low temperature aluminum trichloride AlCl₃ gas by passing HCl through a pre-generator 50 containing aluminum powder or aluminum pellets at a relatively low temperature T3, preferably about 500F. The resultant aluminum trichloride gas is then flowed to the generator 16. The low temperature pre-generator is a cost effective and low temperature method for this step of the process. A preheater 46, preferably in the form of a heat exchanger, which may be powered by a less expensive source of heat than electricity, is also provided to help raise the temperature of the aluminum chloride gas mixture in an efficient and relatively inexpensive fashion. Electrical furnaces, though expensive to operate, are used for the first heating means 30 and the second heating means 34 because they are easy to control, and therefore are used generally to provide the marginal amount of heat required to maintain the desired temperature levels while maintaining the temperature differentials between T1 and T2.

While the preferred embodiment of the present invention has been described fully in order to explain its principles, it is understood that various modifications or alterations may be made to the preferred embodiment without departing from the scope of the invention as set forth in the appended claims.

## Claims

1. A process for coating an article with aluminum wherein the article is made of an alloy having a base metal from a group of metals including cobalt (Co) and nickel (Ni), said process comprising:
continuously generating an aluminum monochloride (AlCl) enriched aluminum chloride gas mixture in a generator operating at a first temperature T1,
continuously flowing the enriched aluminum monochloride gas mixture to a reactor,
reacting the AlCl enriched aluminum chloride gas mixture on at least one article surface by flowing the resultant AlCl enriched aluminum chloride gas mixture from the generator over the surfaces of the articles to be coated in the reactor continuously operating at a second temperature T2,
continuously venting the reacted gases out of the reactor, and
continuously operating the process with T1 at a substantially higher temperature than T2.

2. The process claimed in claim 1 wherein first temperature T1 is at least 25°F higher than second temperature T2.

3. The process claimed in Claim 1 or Claim 2 wherein generating the AlCl enriched aluminum chloride gas mixture further comprises flowing aluminum trichloride gas through aluminum in the generator.

4. The process claimed in Claim 1 or Claim 2 wherein continuously generating the AlCl enriched aluminum chloride gas mixture further comprises bubbling aluminum trichloride gas through molten aluminum in the generator.

5. The process claimed in Claim 1 or Claim 2 wherein continuously generating the AlCl enriched aluminum chloride gas mixture further comprises flowing hydrogen chloride gas through aluminum-containing material in the generator.

6. An article made of an alloy based on a group of metals including cobalt (Co) and nickel (Ni), said article having a surface provided with at least one coating deposited according to the method of any preceding claim.

7. An apparatus for coating the surface of an article with aluminum wherein the article is made of an alloy based on a metal selected from the group consisting of cobalt (Co) and nickel (Ni), said apparatus comprising:
a generator for generating an aluminum monochloride AlCl-enriched aluminum chloride gas mixture at a first temperature T1,
a reactor in fluid communication with said generator and effective for receiving the AlCl-enriched aluminum chloride gas mixture from said generator and reacting the AlCl-enriched aluminum chloride gas mixture on the article surfaces by flowing the AlCl-enriched aluminum chloride gas mixture over the surfaces of the article at a second temperature T2 in said reactor,
vent means for continuously venting the reacted gases out of said reactor, and
control means to continuously maintain said first temperature T1 substantially higher than said second temperature T2 during the reacting step of the coating process.

8. The apparatus as claimed in claim 7 wherein said control means is effective for continuously maintaining said first temperature T1 of said generator at least about 25°F higher than said second temperature T2 of said reactor.

9. The apparatus as claimed in claim 7 wherein said generator for generating the AlCl enriched aluminum chloride gas mixture comprises a means for continuously flowing aluminum trichloride gas through a chamber in said generator containing aluminum.

10. The apparatus as claimed in claim 9 wherein said generator for generating the AlCl-enriched aluminum chloride gas mixture further comprises means for bubbling aluminum trichloride gas through molten aluminum in said chamber.

11. The apparatus as claimed in claim 7 wherein said generator for generating the AlCl-enriched aluminum chloride gas mixture comprises a means for continuously flowing hydrogen chloride gas through a chamber in the generator containing an aluminum source.

12. The apparatus as claimed in claim 7 further comprising a pre-generator for producing said aluminum trichloride gas,
said pre-generator in fluid supply communication with said generator,
said pre-generator effective to produce said aluminum trichloride gas at a lower operating third temperature T3 than said temperature T1 of the generator, and
said pre-generator producing said aluminum trichloride gas by flowing hydrogen chloride gas through aluminum in the pre-generator.
